Europäisches Patentamt

European Patent Office

Office européen des brevets

(19)

(11) Veröffentlichungsnummer: **0 360 211**
**A2**

(12) **EUROPÄISCHE PATENTANMELDUNG**

(21) Anmeldenummer: **89117290.0**

(22) Anmeldetag: **19.09.89**

(51) Int. Cl.5 **G03F 7/16**

(30) Priorität: **23.09.88 DE 3832339**

(43) Veröffentlichungstag der Anmeldung:
**28.03.90 Patentblatt 90/13**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Hilger, Manfred**
**Langenbergring 74**
**D-5503 Konz(DE)**

(54) **Lichtempfindliches Aufzeichnungsmaterial.**

(57) Es werden lichtempfindliche Aufzeichnungsschichten mit einer Dicke im Bereich von 40 bis 200 µm durch Aufeinanderlaminieren dünnerer Aufzeichnungsschichten, unter Zuhilfenahme von geeigneten organischen Lösungsmittelgemischen hergestellt. Dazu werden wassermischbare organische Lösemittel, wie höherwertige Alkohole, mit reinem Wasser gemischt. Unter anderem kommen wäßrige Glycerin- oder Glykolgemische zur Anwendung, die als Flüssigkeitsschichten vor dem Aufeinanderlaminieren der Aufzeichnungsschichten auf die Oberfläche der einen Aufzeichnungsschicht aufgetragen werden. Die Lösungsmittelgemische dringen in die aufeinander zu laminierenden Aufzeichnungsschichten ein, ohne die optischen und anwendungstechnischen Eigenschaften der Aufzeichnungsschichten zu verändern. Das Auflaminieren erfolgt unter Druck und Wärme, und es kommt zu einem nicht mehr trennbaren Verbund der Aufzeichnungsschichten zu einer einzigen dickeren Aufzeichnungsschicht, die im Kontaktbereich der ursprünglichen Aufzeichnungsschichten homogen ist. Auf diese Weise können dicke Aufzeichnungsschichten mit differenzierten Eigenschaften sowie unterschiedlichen Lichtempfindlichkeitsebenen preiswert hergestellt werden.

## LICHTEMPFINDLICHES AUFZEICHNUNGSMATERIAL

Die Erfindung betrifft ein lichtempfindliches Aufzeichnungsmaterial aus einer lichtempfindlichen Aufzeichnungsschicht und einem aus einer Kunststoffolie bestehenden temporären Träger für die Aufzeichnungsschicht.

Derartige Aufzeichnungsschichten bestehen beispielsweise aus Negativ-Fotoresist, der in trockenem Zustand von dem temporären Träger auf einen endgültigen Träger übertragen wird.

Derartige Schichtübertragungsmaterialien sind zum Beispiel aus der DE-AS 15 22 515 bekannt geworden. Die dort beschriebenen lichtempfindlichen Kopierschichten sind lichtvernetzbar oder fotopolymerisierbar, arbeiten also negativ, und eignen sich aufgrund ihres normalen Gehalts an thermoplastischen polymeren Substanzen besonders gut für eine trockene Übertragung der Kopierschicht unter Druck und Erwärmen auf den endgültigen Träger.

In der DE-PS 22 36 941 ist ein einfach aufgebautes Schichtübertragungsmaterial für trockene Übertragung, insbesondere von Fotoresistschichten, beschrieben, das positiv arbeitet und die bekannten Vorteile der Positivschichten mit guter Übertragbarkeit und Haftung auf der endgültigen Unterlage verbindet. Diese bekannten lichtempfindlichen Aufzeichnungsschichten besitzen nicht die sonst von Positivlack-Schichten bekannte Sprödigkeit, sondern sind geschmeidig und können sauber. und sicher wäßrig-alkalisch entwickelt und mit den für Negativ-Trockenresist üblichen Walzenlaminiergeräten in Schichtdicken von etwa 4 bis 60 μm übertragen werden. Schichtdicken von 60 μm und mehr werden durch mehrmaliges Laminieren der Positiv-Trockenresistschichten übereinander mittels Wärme und Druck erreicht.

Aus der EP-B - 0 040 842 ist das Laminieren von Trockenresist auf ein Substrat mittels Druck und unter Aufbringen einer dünnen Flüssigkeitsschicht auf die Substratoberfläche unmittelbar vor dem Laminieren bekannt. Die Substratoberfläche besteht beispielsweise aus einem Metall, das aus der Gruppe Kupfer, Aluminium, Messing, Stahl, chemischen Walzenlegierungen und Mischungen aus diesen ausgewählt wurde. Ferner kann die Substratoberfläche aus einem keramischen oder dielektrischen Material bestehen. Die Flüssigkeit wird unter Wasser, $C_{1-4}$-Alkanolen sowie wäßrigen Lösungen von $C_{1-14}$-Alkanolen ausgewählt oder kann eine Stickstoff enthaltende heterozyklische Verbindung in gelöster Form sein. Ferner kann die dünne Schicht sich von einer gasförmigen Dispersion feinteiliger Flüssigkeitsteilchen mit darin dispergierten Feststoffen ableiten. In bezug auf die thermoplastische Schicht, die auf das Substrat auflaminiert wird, ist die Flüssigkeit ein Nicht-Lösungsmittel.

Zur Herstellung von sehr dicken lichtempfindlichen Aufzeichnungsschichten, wie zum Beispiel von Siebdruckfilmen oder Negativ-Trockenresistfilmen, sind die üblichen Streichmaschinen, mit denen die lichtempfindlichen Aufzeichnungsschichten auf einen Träger aufgetragen werden, nur bedingt geeignet. Um Schichtdicken über 100 μm bis zu etwa 150 μm herstellen zu können, werden sehr hohe Trocknerkapazitäten benötigt. Die üblicherweise eingesetzten Streichmaschinen ermöglichen es, wenn überhaupt, nur durch starke Verminderung der Beschichtungsgeschwindigkeiten, lange Verweilzeiten der wärmeempfindlichen Aufzeichnungsschichten im Trocknungskanal und zeitraubende off-line Beschichtungsverfahren mit Hilfe von Doppelanträgen dicke, funktionsfähige Aufzeichnungsschichten herzustellen. Ebenso können lichtempfindliche Aufzeichnungsschichten mit unterschiedlichem Schichtaufbau durch herkömmliche Beschichtungsverfahren nur mangelhaft erstellt werden.

Stark verminderte Beschichtungsgeschwindigkeiten verursachen lange Verweilzeiten der wärmeempfindlichen Aufzeichnungsschichten im Trocknungskanal und beeinträchtigen somit die Schicht-Eigenschaften, wie Dickengleichmäßigkeit, Folienschrumpf, Aufentwickelbarkeit und Restlösemittelgehalt der Aufzeichnungsschichten. Durch eine zu lange Verweilzeit der sensibilisierten Aufzeichnungsschichten im Trocknungskanal kann eine Veränderung der angestrebten Filmeigenschaften erfolgen. Es sind extrem langsame Beschichtungsgeschwindigkeiten und Mehrschichtanträge im off-line Verfahren notwendig, um beispielsweise lichtempfindliche Aufzeichnungsschichten einer Stärke von 70 bis 150 μm herzustellen. Lichtempfindlichkeit, Tentingverhalten, Haftungseigenschaften, Benetzbarkeit. Entwicklerresistenz, Auflösbarkeit und dergleichen mehr sind Produkteigenschaften von lichtempfindlichen Aufzeichnungsschichten, die in ihren Anforderungen immer stärker differenziert werden müssen, wobei in Hinblick auf eine Eintopfrezeptur die Realisierung schwieriger wird. So werden zum Beispiel bei dickeren Siebdruckfilmen zwei unterschiedliche Lackrezepturen übereinander beschichtet, um eine gezielte Lichtempfindlichkeit und eine schnellere Aufentwicklung zu ermöglichen.

Aufgabe der Erfindung ist es, lichtempfindliche Aufzeichnungsschichten mit differenzierten Produkteigenschaften bzw. Anforderungsprofilen in bezug auf die Lichtempfindlichkeit, Haftung, Benetzbarkeit, Entwicklerresistenz, Auflösbarkeit und dergleichen und mit entsprechend größeren Schichtdicken zu schaffen.

Diese Aufgabe wird erfindungsgemäß dadurch gelöst, daß die Aufzeichnungsschicht ein rein wäßrig entwickelbares Fotopolymerensystem ist und durch Duplieren oder mehrmaliges Laminieren von dünneren Aufzeichnungsschichten unter Einsatz von Lösungsmittelgemischen aus organischen Lösemitteln und Wasser eine vorgegebene Schichtdicke erhält.

Die weitere Ausgestaltung der Erfindung ergibt sich aus den Merkmalen der Unteransprüche 2 bis 6.

Das Verfahren zum Übereinander-Laminieren von zumindest zwei lichtempfindlichen Aufzeichnungsschichten, von denen die untere Aufzeichnungsschicht trägerunterstützt ist, zeichnet sich dadurch aus, daß auf die freie Oberfläche der unteren Aufzeichnungsschicht, die aus rein wäßrig aufentwickelbaren Fotopolymeren besteht, eine dünne Flüssigkeitsschicht als Bindemittel vor dem Auflaminieren einer weiteren gleichartigen Aufzeichnungsschicht aufgebracht wird, daß der Überschuß an aufgebrachtem Bindemittel an der Auflaminierstelle der weiteren Aufzeichnungsschicht abgequetscht wird und daß das Bindemittel in die Aufzeichnungsschichten umgekehrt proportional zu seiner Molgröße und Wertigkeit eindringt, ohne chemische oder optische Veränderungen der Aufzeichnungsschichten hervorzurufen.

Die weitere verfahrensmäßige Ausgestaltung der Erfindung ergibt sich aus den Verfahrensmaßnahmen nach den Ansprüchen 8 bis 15.

Die Erfindung wird im folgenden anhand der einzigen schematischen Zeichnung näher erläutert.

Auf einer Vorratsrolle 1 befindet sich ein Aufzeichnungsmaterial 2, beispielsweise ein Siebdruckfilmmaterial, bestehend aus einer lichtempfindlichen Aufzeichnungsschicht $2''$, die auf einem Träger $2'$, einer Polyesterfolie oder Polypropylenfolie aufgetragen ist. Die Polypropylen- bzw. Polyesterfolie hat im allgemeinen eine Dicke zwischen 12 und 75 $\mu$m. Die Dicke der Aufzeichnungsschicht, die u. a. auch aus einem Negativ-Trockenfotoresist bestehen kann, liegt zwischen 7,5 und 40 $\mu$m, insbesondere zwischen 7,5 und 25 $\mu$m. Von der Vorratsrolle 1 wird das Aufzeichnungsmaterial 2 schräg abgezogen und über eine Umlenkrolle 3 horizontal in Richtung eines Quetschwalzenpaares 5 und 6 umgelenkt. Vor diesem Quetschwalzenpaar ist oberhalb der Bahn des Aufzeichungsmaterials 2 eine Zerstäubervorrichtung 4 angeordnet, die ein Lösungsmittelgemisch aus einem organischen Lösemittel und Wasser enthält. Durch ein Zerstäuberrohr 11, das mit der Zerstäubervorrichtung 4 verbunden ist, wird dieses Lösungsmittelgemisch auf die Aufzeichnungsschicht $2''$ fein zerstäubt aufgebracht, so daß sich eine Flüssigkeitsschicht aus dem Lösungsmittelgemisch auf der Oberfläche der Aufzeichnungsschicht $2''$ vor dem Eintritt des Aufzeichnungsmaterials 2 in einen Kaschierspalt 7 der beiden Quetschwalzen 5 und 6 ausbildet.

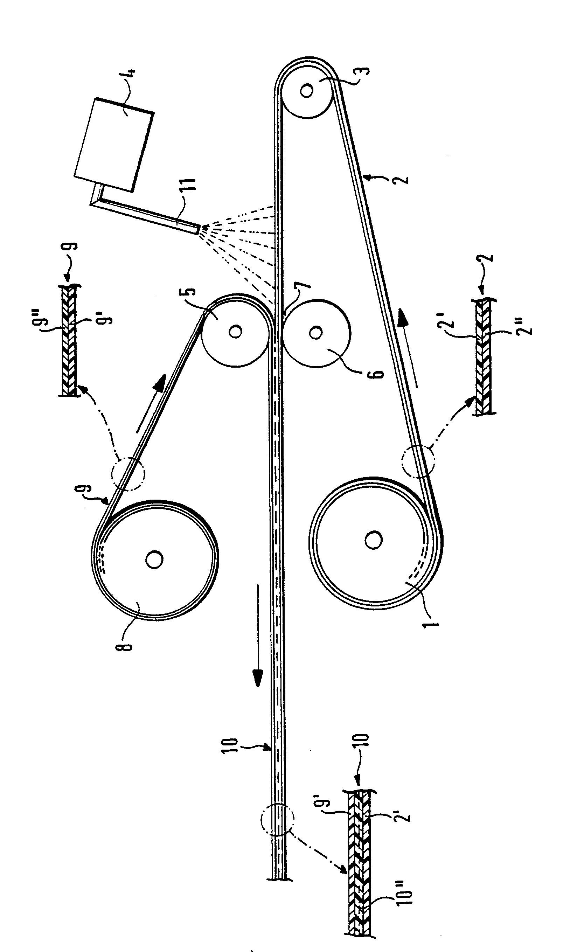

Oberhalb der horizontal verlaufenden Bahn des Aufzeichnungsmaterials befindet sich eine weitere Vorratsrolle 8 eines Aufzeichnungsmaterials 9, das aus einer Aufzeichnungsschicht $9''$ und einem Träger $9'$ besteht, der beim Abwickeln des Aufzeichnungsmaterials 9 nach unten zeigt. Der Träger $9'$ ist im allgemeinen aus dem gleichen Material wie der Träger $2'$. Die Aufzeichnungsschicht $9''$ kann die gleiche oder eine andere Zusammensetzung wie die Aufzeichnungsschicht $2''$ besitzen. Das Aufzeichnungsmaterial 9 wird in Richtung der Auflaminierstelle dem Kaschierspalt 7 zugeführt und um die obere Quetschwalze 5 herum in den Kaschierspalt 7 gelenkt. Die beiden Quetschwalzen 5 und 6 sind beheizt, und die Heizwalzentemperatur beträgt beispielsweise 110 bis 115 °C. Im Kaschierspalt 7 wird der überschüssige Anteil der Flüssigkeitsschicht abgequetscht und die beiden Aufzeichnungsmaterialien 2 und 9 deckungsgleich zusammengefügt, so daß sich die Aufzeichnungsschichten $2''$ und $9''$ kontaktieren. Nach dem Durchlaufen der beiden übereinander laminierten Aufzeichnungsmaterialien 2 und 9 des Kaschierspalts 7 wird ein Sandwich-Aufzeichnungsmaterial 10 erhalten, dessen laminierte Aufzeichnungsschicht $10''$ beidseitig von den Trägern $2'$ und $9'$ eingeschlossen wird. In dem Detailausschnitt der Zeichnung, der einen vergrößerten Querschnitt durch das Sandwich-Aufzeichnungsmaterial 10 wiedergibt, durchzieht die Aufzeichnungsschicht $10''$ eine gestrichelte Linie, die andeutet, daß sich die Aufzeichnungsschicht $10''$ aus den ursprünglichen Aufzeichnungsschichten $2''$ und $9''$ zusammensetzt, wobei die gestrichelte Linie die Kontaktebene dieser beiden ursprünglichen Aufzeichnungsschichten anzeigt.

Nach dem Abzug des oberen Trägers $9'$ von dem Sandwich-Aufzeichnungsmaterial 10 kann die Aufzeichnungsschicht $10''$ von dem temporären Träger $2'$ auf einen endgültigen Träger übertragen werden. Das erhaltene Sandwich-Aufzeichnungsmaterial 10 zeigt eine sehr homogene Qualität der laminierten Aufzeichnungsschicht $10''$ mit hoher Verbundfestigkeit. Das Sandwich-Aufzeichnungsmaterial 10 ist frei von visuell erkennbaren Veränderungen, und die laminierte Aufzeichnungsschicht $10''$ ist nicht mehr auftrennbar. Selbst ein Überschuß an Lösungsmittelgemisch bzw. an Bindemittelflüssigkeit beeinflußt die Oberflächenzusammensetzung der Aufzeichnungsschicht $10''$ nicht. Zweckmäßigerweise wird ein geeignetes Netzmittel dem Lösungsmittelgemisch zugesetzt, um eine bessere Verteilung der Flüssigkeitsschicht bzw. eine schnellere Benetzbarkeit der aufeinander aufzulaminierenden Aufzeichnungsschichten zu erzielen.

Als Netzmittel, die die Verlaufseigenschaften des Lösungsmittelgemisches verbessern, sind nichtionische, anionische und kationische Netzmittel geeignet. Zur ersten Gruppe zählen u.a. Tributylphenolpolyglykolether, Alkylphenolpolyglykolether mit 20 Oxyethyleneinheiten und Nonylphenol-Polyglykolether. Anionische Netzmittel sind beispielsweise sekundäres Alkansulfonat als 60-%ige Lösung in Wasser, Fettsäuresarkosid als Na-Salz, gleichfalls in 60%iger Lösung in Wasser, und Alkylarylsulfonat als Na-Salz in 65%iger Lösung in Wasser. Zu den kationischen Netzmitteln gehören vor allem Dodecyl- und Octadecyltrimethlyammoniumchlorid.

Da die Lösungsmittelgemische im neutralen pH-Bereich liegen, werden in erster Linie nichtionische oder anionische Netzmittel eingesetzt, mit einer Netzmittelkonzentration zwischen 0,1 bis 0,5 Gew.%.

Obgleich dies nicht dargestellt ist, können auch drei oder noch mehr Aufzeichnungsschichten in ähnlicher Weise, wie dies anhand der Zeichnung beschrieben wurde, aufeinanderlaminiert werden. Das Aufbringen einer Flüssigkeitsschicht auf die untere Aufzeichnungsschicht kann insbesondere über einen direkten Rasterwalzenantrag bzw. einen indirekten Rasterwalzenantrag mit Hilfe von Gummiübertragungswalzen erfolgen. Das anschließende Laminieren wird mit genau definiertem Andruck der Quetschwalzen unter Vermeidung von Lufteinschlüssen durchgeführt.

Die Flüssigkeitsschicht kann auch in der Weise hergestellt werden, daß das Lösungsmittelgemisch als Dampf oder als Aerosol auf die Oberfläche der Aufzeichnungsschicht aufgetragen wird, wobei die Temperatur der Oberfläche der Aufzeichnungsschicht unterhalb des Taupunktes des Dampfes gehalten wird. Durch die Taupunktsunterschreitung schlägt sich das Lösungsmittel aus dem Dampf als Flüssigkeitsschicht bzw. Flüssigkeitsniederschlag auf der Oberfläche der Aufzeichnungsschicht nieder.

Die Lösungsmittelgemische bestehen aus ein- oder mehrwertigen Alkoholen und Wasser und weisen ausgezeichnete Klebeeigenschaften für die wäßrig aufentwickelbaren Fotopolymerensysteme der Aufzeichnungsschichten auf, ohne daß sich dabei die optischen und die anwendungstechnischen Eigenschaften der aufeinander zu laminierenden Aufzeichnungsschichten verändern. Die Eindringeigenschaften der Lösungsmittelgemische verändern sich sehr stark mit steigendem Molgewicht der verwendeten Alkohole. Dabei zeigt sich, daß die Eindringgeschwin digkeiten der Lösungsmittelgemische umgekehrt proportional zur Molgröße und zur Wertigkeit des verwendeten Alkohols sind. Geeignete Alkohole werden aus der Gruppe Ethylalkohol, Ethylenglykol, Polyethylenglykol, Glycerin, Methylglykol, Ethylglykol und Butylglykol ausgewählt.

Sehr gute Ergebnisse werden mit einem Lösungsmittelgemisch erzielt, das aus einer wäßrigen Glycerinlösung mit 65 bis 75 Gew.% Glycerin, insbesondere 70 Gew.% Glycerin, 29,7 Gew.% Wasser und 0,3 Gew.% eines Netzmittels, wie eines Alkylphenolpolyglykolethers mit 20 Oxyethyleneinheiten, besteht. Eine Abweichung von 10 Gew.% Glycerin von dem Mittelwert von 70 Gew.% Glycerin liefert schon unerwünschte Veränderungen der Eigenschaften und des optischen Aussehens der Aufzeichnungsschicht.

Aufgrund ihrer hydrophilen Eigenschaften verändern die wäßrig aufentwickelbaren Polymersysteme der Aufzeichnungsschichten ihre Adhäsionskräfte je nach Feuchtigkeitsgehalt und Zusammensetzung der Flüssigkeitsschicht aus Lösungsmittelgemischen. Dabei zeigen Versuche, daß beispielsweise das Auflaminieren von Fotopolymerschichten unter alleiniger Zuhilfenahme von Wasser zu einem unkontrollierten und zu tiefen Eindringen des Wassers in die miteinander zu laminierenden Aufzeichnungsschichten führt und Hand in Hand damit visuelle und chemische Veränderungen der Eigenschaften der Aufzeichnungsschichten auftreten. Durch die voran stehend angeführten Lösungsmittelgemische aus organischen Lösemitteln und Wasser können Flüssigkeiten mit gutem Klebeverhalten hergestellt werden, die beim Aufbringen auf die Oberflächen der miteinander zu laminierenden Aufzeichnungsschichten weder optische noch chemische Veränderungen hervorrufen.

Durch die Möglichkeit, lichtempfindliche Aufzeichnungsschichten mit Hilfe eines Lösungsmittelgemisches zu duplizieren bzw. mehrfach miteinander zu laminieren, können Aufzeichnungsschichten mit wesentlich höheren Dicken als bei der üblichen Beschichtungstechnik hergestellt werden. Die Dicke der laminierten Aufzeichnungsschicht liegt im Bereich von 40 bis 150 "m, insbesondere bei 70 "m. Es können dabei gleiche Aufzeichnungsschichten oder unterschiedlich zusammengesetzte Aufzeichnungsschichten miteinander verbunden werden, wobei mit den Anwendungseigenschaften der einzelnen Aufzeichnungsschicht unterschiedliche Zielsetzungen angestrebt werden. So ist es beispielsweise möglich, Aufzeichnungsschichten mit unterschiedlichen Lichtempfindlichkeiten miteinander zu laminieren, so daß im Inneren der dann erhaltenen dickeren Aufzeichnungsschicht verschiedene Lichtempfindlichkeitsebenen bestehen. Ebenso können die Haftungseigenschaften der erhaltenen dickeren Aufzeichnungsschicht gegenüber dem Basisträger und gegenüber dem Deckträger differenziert werden. Die einzelnen Aufzeichnungsschichten, die miteinander laminiert werden, können dabei nach mehreren Rezepturen zusammengestellt sein, um eine dickere zu sammengesetzte Aufzeichnungsschicht zu erhalten, die mit Hilfe einer sogenannten Eintopfrezeptur nicht oder nur sehr schwierig realisierbar wäre.

## Ansprüche

1. Lichtempfindliches Aufzeichnungsmaterial aus einer lichtempfindlichen Aufzeichnungsschicht und einem aus einer Kunststofffolie bestehenden temporären Träger für die Aufzeichnungsschicht, dadurch gekennzeichnet, daß die Aufzeichnungsschicht ein rein wäßrig entwickelbares Fotopolymerensystem ist und durch Dublieren oder mehrmaliges Laminieren von dünneren Aufzeichnungsschichten unter Einsatz von Lösungsmittelgemischen aus organischen Lösemitteln und Wasser eine vorgegebene Schichtdicke aufweist.

2. Lichtempfindliches Aufzeichnungsmaterial nach Anspruch 1, dadurch gekennzeichnet, daß die Lösungsmittelgemische aus ein- oder mehrwertigen Alkoholen und Wasser bestehen.

3. Lichtempfindliches Aufzeichnungsmaterial nach Anspruch 2, dadurch gekennzeichnet, daß die Lösungsmittelgemische Ethylalkohol, Ethylenglykol, Polyethylenglykol, Glycerin, Methylglykol, Ethylglykol oder Butylglykol enthalten.

4. Lichtempfindliches Aufzeichnungsmaterial nach Anspruch 3, dadurch gekennzeichnet, daß die Lösungsmittelgemische 65 bis 75 Gew.% Alkohol in Wasser enthalten.

5. Lichtempfindliches Aufzeichnungsmaterial nach Anspruch 4, dadurch gekennzeichnet, daß der im Lösungsmittelgemisch enthaltene Alkohol Glycerin mit 70 Gew.% in Wasser ist.

6. Lichtempfindliches Aufzeichnungsmaterial nach den Ansprüchen 1 bis 5, dadurch gekennzeichnet, daß die Dicke der laminierten Aufzeichnungsschicht 40 bis 200 μm, insbesondere 100 μm, beträgt und daß die einzelnen Aufzeichnungsschichten die gleiche oder unterschiedliche Zusammensetzung besitzen.

7. Verfahren zum Übereinanderlamininieren von zumindest zwei lichtempfindlichen Aufzeichnungsschichten, von denen die untere Aufzeichnungsschicht trägerunterstützt ist, dadurch gekennzeichnet, daß auf die freie Oberfläche der unteren Aufzeichnungsschicht, die aus rein wäßrig aufentwikkelbaren Fotopolymeren besteht, eine dünne Flüssigkeitsschicht als Bindemittel vor dem Auflaminieren einer weiteren Aufzeichnungsschicht aufgebracht wird, daß der Überschuß an aufgebrachtem Bindemittel an der Auflaminierstelle der weiteren Aufzeichnungsschicht abgequetscht wird und daß das Bindemittel in die Aufzeichnungsschichten umgekehrt proportional zu seiner Molgröße und Wertigkeit eindringt, ohne chemische oder optische Veränderungen der Aufzeichnungsschichten hervorzurufen.

8. Verfahren nach Anspruch 7, dadurch gekennzeichnet, daß die wäßrige Flüssigkeitsschicht auf die freie Oberfläche der Aufzeichnungsschicht vor der Auflaminierstelle aufgesprüht wird oder durch einen Überschuß an dem Lösungsmittelgemisch zur Bildung der Flüssigkeitsschicht vor der Auflaminierstelle erzeugt wird.

9. Verfahren nach Anspruch 8, dadurch gekennzeichnet, daß der Flüssigkeitsschicht bzw. dem Lösungsmittelgemisch ein Netzmittel zum schnelleren Benetzen der Oberflächen der zu laminierenden Aufzeichnungsschichten zugesetzt wird.

10. Verfahren nach den Ansprüchen 7 und 8, dadurch gekennzeichnet, daß das deckungsgleiche Laminieren der Aufzeichnungsschichten unter Druck und Wärme erfolgt.

11. Verfahren nach Anspruch 7, dadurch gekennzeichnet, daß die Flüssigkeitsschicht in der Weise hergestellt wird, daß das Lösungsmittelgemisch als Dampf oder als Aerosol auf die Oberfläche der Aufzeichnungsschicht aufgetragen wird, wobei die Temperatur der Oberfläche der Aufzeichnungsschicht unterhalb des Taupunktes des Dampfes gehalten wird.

12. Verfahren nach Anspruch 7, dadurch gekennzeichnet, daß für das Lösungsmittelgemisch ein- oder mehrwertige Alkohole, gelöst in Wasser, ausgewählt werden.

13. Verfahren nach Anspruch 12, dadurch gekennzeichnet, daß ein Alkohol aus der Gruppe Ethylalkohol, Ethylenglykol, Polyethylenglykol, Glycerin, Methyl glykol, Ethylglykol und Butylglykol ausgewählt wird.

14. Verfahren nach Anspruch 13, dadurch gekennzeichnet, daß als Lösungsmittelgemisch eine 70 Gew.% Glycerin enthaltende wäßrige Glycerinlösung verwendet wird.

15. Verfahren nach Anpsruch 9, dadurch gekennzeichnet, daß ein nichtionisches, anionisches oder ein kationisches Netzmittel, mit einer Netzmittelkonzentration von 0,1 bis 0,5 Gew.%, dem Lösungsmittelgemisch zugesetzt wird.